# EUROPEAN PATENT SPECIFICATION

(11) **EP 3 655 996 B1**
(45) Date of publication and mention of the grant of the patent: **05.05.2021**
(21) Application number: 18742495.7
(22) Date of filing: 19.07.2018
(51) Int. Cl.: H01L 31/0392, H01L 31/0749

(54) **CIGS BASED THIN-FILM SOLAR CELLS ON METAL SUBSTRATE**
CIGS-BASIERTE DÜNNSCHICHTSOLARZELLEN AUF METALLSUBSTRAT
CELLULES SOLAIRES À COUCHE MINCE À BASE DE CIGS SUR UN SUBSTRAT MÉTALLIQUE

(30) Priority: 20.07.2017 EP 17182453
(43) Date of publication of application: 27.05.2020
(73) Proprietor: Tata Steel Nederland Technology B.V., 1951 JZ Velsen-Noord (NL)
(72) Inventor: PALANISWAMY, Ganesan, 1970 CA IJmuiden (NL); WIJENBERG, Jacques Hubert Olga Joseph, 1970 CA IJmuiden (NL)
(74) Representative: Group Intellectual Property Services
(86) International application number: PCT/EP2018/069660
(87) International publication number: WO 2019/016325

(56) References cited:
- US-A1- 2007 145 507
- A. KAMPMANN ET AL: "Electrodeposition of CIGS on Metal Substrates", MRS PROCEEDINGS, vol. 763, 1 January 2003 (2003-01-01), pages 1-5, XP055438404, DOI: 10.1557/PROC-763-B8.5

## Description

This invention relates to a low cost metal substrates for CIGS thin-film solar cell.

A copper indium gallium selenide solar cell (or CIGS cell) is a thin-film solar cell used to convert sunlight into electric power. CIGS is a I-III-VI₂ compound semiconductor material composed of copper, indium, gallium, and selenium. The material is a solid solution of copper indium selenide (often abbreviated "CIS") and copper gallium selenide, with a chemical formula of CuInₓGa₍₁₋ₓ₎Se₂, where the value of x can vary from 1 (pure copper indium selenide) to 0 (pure copper gallium selenide). The bandgap varies continuously with x from about 1.0 eV (for copper indium selenide) to about 1.7 eV (for copper gallium selenide).

The efficiency of thin film Cu(In,Ga)Se₂ (CIGS) has steadily increased in the past years and maximum conversion efficiency of 22.6 % for CIGS on rigid glass substrate was reported. These glass based solar cells are heavy and brittle, and produced by a batch process. With process modifications CIGS solar cells can also be fabricated on flexible substrates e.g. stainless steel or polyimide, which facilitates cost effective roll-to-roll production. The realization of high efficiency solar cells in a fully roll-to-roll compatible process based on common mild steel foils might allow to further reducing costs of solar modules. In recent years progress has been made using stainless steel foil as a substrate material. A certified efficiency of 17.7 % has been achieved on stainless steel using a low temperature CIGS deposition process and 17.6 % efficiency was achieved for CIGS grown on an enamelled mild steel substrate. Modules with about ∼16% efficiency are already available with stainless steel substrates.

The electrical performance of CIGS solar cells on mild steel substrates is known to deteriorate due to the diffusion of elements like Fe, Mn, Al etc. into the CIGS active layer during processing at high temperatures.

Many studies have been performed to mitigate this A. KAMPMANN ET AL, "Electrodeposition of CIGS on Metal Substrates", MRS PROCEEDINGS, vol. 763, 2003, pages 1-5, discloses a CIGS-based thin-film solar cell, comprising a steel substrate coated with chromium wherein the coated steel substrate is further coated with a CIGS-based solar cell comprising a molybdenum back contact layer, a CIGS active layer, an n-type semiconductor layer such as a CdS layer and a transparent conductive oxide layer (ZnO).

The object of this invention is to provide a low cost CIGS thin-film solar cell that does not suffer from electrical performance losses.

The object of this invention is also to provide a low cost flexible CIGS thin-film solar cell that can be produced in a roll-to-roll production.

Another object of the invention is to provide a method of producing said low cost flexible CIGS thin-film solar cells.

Another object of the invention is to provide a method of producing corrosion resistant low cost flexible CIGS thin-film solar cells.

Another object of the invention is to provide a low cost flexible CIGS thin-film solar with an efficiency of at least 15% when depositing the CIGS layer at 450 °C.

Another object of the invention is to provide a low cost flexible CIGS thin-film solar with an efficiency of at least 14% when depositing the CIGS layer at 500 °C.

One or more of these objects is reached by the invention embodied in claim 1. Preferred embodiments are provided in the dependent claims 2 to 8.

The advantage of the solar cell according to the invention is that the mild steel substrate can be produced at low cost, and the nickel and chromium layer can be applied using electrodeposition in commercial coating lines. Consequently the coated mild steel substrate is relatively inexpensive. Also, the thermal expansion coefficient of mild steel is comparable to that of CIGS absorber layers (αₜₛₜₑₑₗ=11-13·10⁻⁶ K⁻¹, α_{CIGS}=8-9·10⁻⁶ K⁻¹ at 20°C). The stability of the mild-steel substrate (thermally and chemically) is good, compared to that of polyimide which starts to degrade at temperatures above 450 °C. The coated mild steel substrate is also corrosion resistant. The formability of the steel substrate is also a big advantage because it can be formed into the desired shape easily or it can be used as a load bearing component in (e.g.) a roof structure. The nickel and chromium layer form an effective barrier to prevent the deterioration in electrical performance of CIGS solar cells due to the diffusion of elements like Fe, Mn, Al into the CIGS active layer during processing at high temperatures and electrical performance losses are the result. The Fe, Mn and Al from the mild steel substrate do not diffuse through the Ni-Cr barrier layer or at least do not pass the critical concentration limits. It is important that the nickel layer and the chromium layer after deposition onto the mild steel substrate are not subjected to a high temperature annealing before the CIGS application process. If the mild steel substrate needs to be recrystallisation or recovery annealed, then this has to be done before applying the nickel layer and the chromium layer, because otherwise the impurity elements will diffuse into the nickel layer and the chromium layer and diffuse through the molybdenum back contact layer during the growing of the CIGS absorber layer and finally potentially end up in the CIGS absorber layer. The inventors found that it is important to keep the iron content in the CIGS absorber layer as low as possible, preferably below 20 ppm, more preferably below 7 ppm.

It is noted that the mild steel substrate may be provided on both sides with the same barrier layer. However, usually the other side (referred to as bottom side for convenience) often only needs protection against corrosion and there is no need to block the transfer of detrimental elements on the bottom side, so in most cases a conventional size nickel layer or zinc layer is sufficient for corrosion protection. Even an organic coating system such as a paint, or a lacquer or thermoplastic film could be used as coating of the bottom side. If left uncoated, the bottom side would be prone to corrosion of the mild steel. It should be noted however, that any coating layer may be provided on the bottom side and the invention is not limited to any particular coating on the bottom side, as long as the barrier layer on the top side is according to the invention.

In the barrier layer according to the invention the nickel layer thickness is between 0.25 and 5.5 µm, and the chromium layer thickness is between 0.01 (10 nm) and 0.30 µm (300 nm). In the presence of a dielectric layer the Ni and Cr layer can be thinner than without a dielectric layer. A suitable minimum chromium layer thickness is 15 nm. A suitable maximum chromium layer thickness is at most 200 nm, preferably at most 150 nm. A suitable minimum nickel layer thickness is 0.4 µm. A suitable maximum nickel layer thickness is at most 3.5 µm, preferably at most 2.5 µm.

In a preferable embodiment the nickel layer thickness is between 1.75 and 2.5 µm and/or the chromium layer thickness is between 0.075 and 0.125 µm. These layer thicknesses are particularly suitable for CIGS process temperature between 450 - 500 °C and the modules are made using the shingling approach. For the monolithical approach there has to be a dielectric layer and therefore the nickel and chromium layers can be thinner, and the dielectric layers also prevents the movement of detrimental elements to the CIGS layer, depending on the nature of the coating.

Using the Ni+Cr barrier layer the diffusion of detrimental elements from the substrate into the absorber could be blocked to below the detection limit of SIMS measurements and no additional defect levels could be observed using admittance spectroscopy.

The steel substrate can be of varying thickness from 25 µm to 3 mm. The lower thickness forms a flexible solar module, whereas thicknesses of over 0.3 mm can take a rigid form or even be directly integrated to building elements, in which case an electrically insulating layer is applied. The steel grade itself is not critical, and any low carbon (LC), extra low-carbon (ELC) or ultra-low carbon (ULC) could be used. Suitable steels are the steels DC01 to DC07 as defined by EN 10130:2006, e.g. in table 2. Preferably the surface condition of the steels is bright (Rₐ ≦ 0.4 µm, EN 10130:2006) or mirror-like (Rₐ ≦ 0.10 µm, more preferably Ra ≦ 0.08 µm) to minimise the possible negative effects of surface roughness. For the sake of avoiding any misunderstanding: the term mild steel (also referred to as plain-carbon steel or low carbon steel) specifically excludes stainless steel (aka inox).

The performance of the Ni+Cr barrier layer depends on the temperature used in the CIGS process. Generally these temperatures vary on the type of process used - between 250 - 700 °C. The higher the growing temperature and the longer the growing process of the CIGS absorber layer, the higher the risk of impurity diffusing through the barrier layer.

The standard back-electrode is a molybdenum layer and usually deposited with a direct current/magnetron sputtering process. The thickness of this layer is between 300 and 750 nm, and preferably about 600 nm.

The CIGS absorber layer can be deposited by different known processes such as printing nano particles; sputtering Cu, In & Ga followed by selenization; electroplating Cu, In & Ga and selenization; co-evaporation of Cu, In, Ga & Se (low & high temperature processes) and spraying pre-cursors and sinter to get the CIGS crystal.

A thin (∼50-80 nm) CdS-layer is used to form a p-n junction layer. This layer is applied using Chemical Bath Deposition technique, which is a standard. Alternative Cd free layers such as ZnS are used nowadays, which are deposited using a vacuum process.

The transparent conductive oxide (TCO) layer can either be ZnO:AI (ZnO doped with Al) or indium tin oxide (InSnOx) or SnOx doped with F, which are applied by sputtering process. This layer varies between 300 - 800 nm and optionally a metallic grid is applied on top of them.

Optionally, a thin i-ZnO layer is deposited between the semiconductor layer and the TCO layer to maximize the performance of the solar cell. The thin layer of intrinsic zinc oxide is preferably between 50 and 100 nm. The layer has a high electric resistivity and good optical transmittance. In addition, it is believed that another benefit of the i-ZnO layer is that it can protect the underlying semiconductor layer from sputter damage in the subsequent step of the fabrication process, where a transparent conducting oxide (TCO) is sputtered on top of the i-ZnO.

The optional dielectric layer between the molybdenum back contact layer and the barrier layer is usually sputtered or applied by means of solution processed methods. The dielectric layer can be metal oxides, nitrides or carbides such as alumina, silicon nitrides, titanium nitride or their respective carbides. Alumina is preferably deposited by means of a sol-gel method because of the speed of this process, although it can also be applied by means of the much slower sputtering method. The latter provides a purer and/or denser alumina layer but at the expense of production speed, and the performance of the sol-gel based alumina layer is adequate. The total thickness of the dielectric layer is preferably at least 2000 nm. The thicker the layer, the higher ability of the layer to prevent migration of detrimental elements into the CIGS absorber layer and result in higher breakthrough voltage.

When all the layers are deposited, the modules can be made using the known Shingling approach or using the known monolithical approach. It is noted that for the monolithical approach the dielectric layer is needed between the barrier layer and Mo back electrode.

When the modules are made, they are encapsulated to protect them from moisture and oxygen so that these modules last for many years.

According to a second aspect a method is provided to produce the low cost flexible CIGS thin-film solar cells according to the invention in claim 9. Preferred embodiments are provided in the dependent claims 10 to 15.

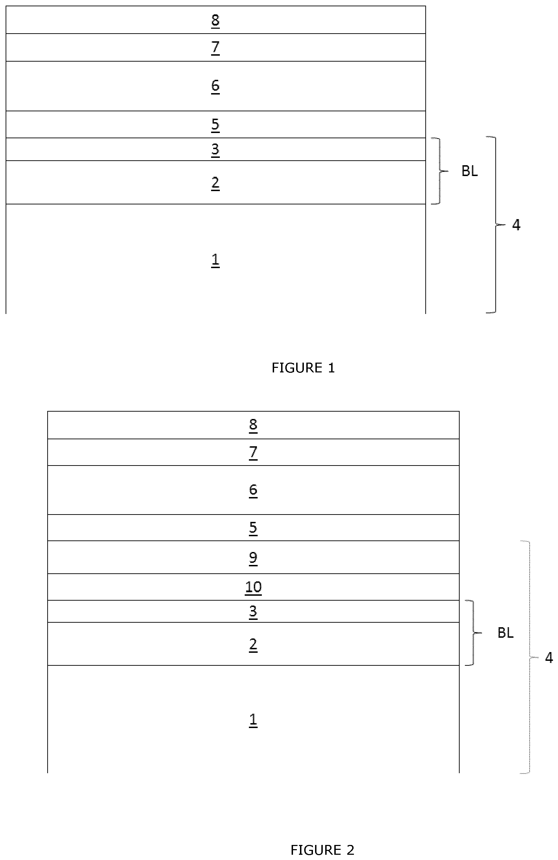

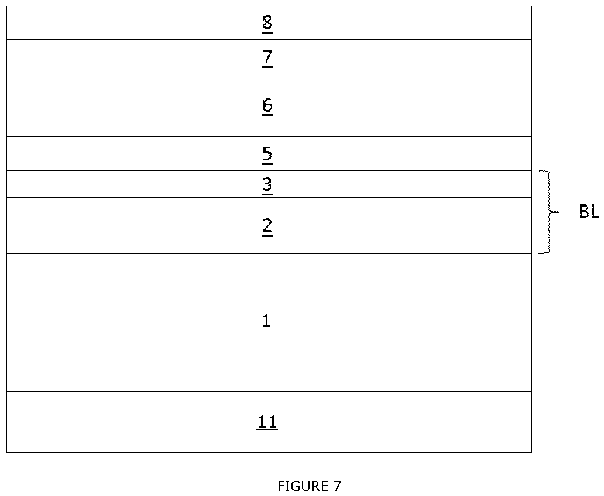

Figure 1 shows a schematic build-up of a solar cell according to the invention (not to scale) and the various layers are indicated. A mild steel substrate 1 is provided with a nickel layer 2 on top of the mild steel substrate and a chromium layer 3 on top of the nickel layer to form a coated mild steel substrate 4. The nickel layer and the chromium layer jointly are referred to as the barrier layer. On the barrier layer a molybdenum back contact layer 5 is provided, followed by a CIGS active layer (aka absorber layer) 6, an n-type semiconductor layer 7 such as a CdS layer (as depicted in the figure) or a ZnS layer and a TCO layer 8. Optionally, a thin i-ZnO layer is deposited between the semiconductor layer 7 and the TCO layer 8 to maximize the performance of the solar cell. The i-ZnO layer is not shown in Figure 1 and 2. The metal grid, such as a Ni/Al grid, and an anti-reflection coating, such as MgF₂-layer, on top of the TCO are not drawn. Instead of the CdS layer 7 a ZnS layer 7 may be used. In Figure 2 the same build-up is shown with an optional dielectric layer 9 between the coated mild steel substrate 4 and the molybdenum back contact layer, to enable monolithical interconnection of cells, and with an optional TiN barrier layer 10. Within the context of this invention the optional dielectric layer and the optional TiN barrier layer, if present, are part of the coated mild steel substrate. Figure 7 shows the same structure on the top surface of the mild steel substrate as in figure 1, and a further corrosion protective layer 11, such as a nickel layer, or any other suitable corrosion protective layer, such as a nickel and chromium layer such as the one on the barrier layer on the top surface. The metal layers making up the barrier layer on the top surface and the corrosion protective layer on the bottom surface of the mild steel substrate can be deposited simultaneously, i.e. a nickel layer may be deposited on both sides simultaneously, followed by other metal layers. In another embodiment the same structure on the top surface of the mild steel substrate as in figure 2 is combined with a further corrosion protective layer 11 on the bottom surface of the mild steel substrate, such as a nickel layer, or any other suitable corrosion protective layer, just as in Figure 7.

CIGS solar cells were grown onto different substrates at 450 °C. The results in terms of efficiency and consistency are shown in the table below. Several examples exceed the 15% threshold for efficiency. A measure for the consistency is given by the percentage of cells having a lower efficiency of between 5 and 10, and below 5%. If the achievable efficiency is over 15% and the number of cells below 10 and 5% is low, then there is a good consistency. The table clearly shows the superiority of the Ni+Cr layers, provided the Ni-layer is not subjected to an annealing treatment (samples 10-13). The consistency of samples 12 and 13 is quite good, but the overall efficiency and other cell parameters are not good enough. It should be noted that the chromium layer in samples 8 and 9 were produced from different electrolytes, and that for the electrolyte of sample 9 no corrector was used because this contains iron, and this iron would end up in the coating layer. Instead 20 g/l KCI was added to the electrolyte.

CIGS solar cells were processed on different Ni+Cr coated mild steel substrates (see Table 1). 600 nm thick Molybdenum back contacts were deposited by direct current (DC) sputtering. Subsequently, CIGS absorber layers were deposited by a multistage co-evaporation method at different nominal substrate temperatures of 450 °C and 500 °C. 450°C corresponds to the standard low temperature process. Devices were finished by a chemically deposited CdS buffer layer, sputtered i-ZnO/ZnO:Al window layer and electron-beam evaporated Ni/Al grids and covered with MgF₂ anti reflection coating.

In some cases TiN barrier layers were applied between the barrier layer and the molybdenum back contact. The TiN barrier layer is composed of a DC sputtered [Ar=21 sccm, p=8.5*10⁻³, Power = 2 W/cm²] 20 nm thick metallic Ti adhesion layer and a DC sputtered [Ar=21 sccm, N=10 sccm, p=5*10⁻³mbar, Power=3W/cm²] 250 nm TiN barrier layer. If a TiN barrier layer and a dielectric layer is used then the TiN barrier layer is applied first, and the dielectric layer is applied on top of the TiN barrier layer (See Figure 2).

**Table 1 - CIGS deposition at 450 °C**

| Sample No. | Description | Ni-layer (µm) | Cr-layer (nm) | Eff (%) | 5-10% | <5% |
|---|---|---|---|---|---|---|
| 1 | BP+MF + Cr | - | 7 | 13.1 | 51 | 22 |
| 2 | BP+MF + Cr | - | 15 | 15.7 | 8 | 0 |
| 3 | BP+MF + Cr* | - | 100 | 15.9 | 48 | 15 |
| 4 | BP+MF + Cr** | - | 100 | 13.5 | 44 | 26 |
| 5 | BP+MF + Ni**** + Cr | 2 | - | 6.2 | 100 | 52 |
| 6 | BP+MF + Ni + Cr | 2 | 7 | 10.8 | 65 | 71 |
| 8 | BP+MF + Ni + Cr* | 2 | 100 | 15.1 | 0 | 0 |
| 9 | BP+MF + Ni + Cr** | 2 | 100 | 15.3 | 6 | 0 |
| 10 | DA*** after Ni-plating +Cr | 2 | 7 | 13.1 | 60 | 35 |
| 11 | DA after Ni-plating +Cr | 2 | 15 | 12.2 | 53 | 21 |
| 12 | DA after Ni-plating +Cr | 2 | 100 | 14.1 | 4 | 0 |
| 13 | DA after Ni-plating +Cr | 2 | 100 | 14.4 | 0 | 11 |

| | | | | | | |
|---|---|---|---|---|---|---|
| Trivalent chromium Trilyte® electrolyte provided by Enthone. **Trivalent chromium TriChrome® Plus electrolyte provided by Atotech. *** DA = Diffusion annealing as a result of recrystallisation annealing of full-hard substrate. **** Deposited from standard Watts nickel bath (Nickel(II)sulphate (270 g/l), Nickel(II)Chloride (50 g/l), Boric Acid (30 g/l), wetting agent, deposition at 55 °C, CD ∼5 A/dm². | | | | | | |

The chromium layers of samples 1 and 2 are thin layers used for packaging steels (TccT®) which are not 100% metallic but rather a mixture of chromium and chromium oxide. It should be noted that all used chromium electrolytes are based on trivalent chromium, and that no hexavalent chromium is used.

**Table 2 - CIGS deposition at 500 °C**

| Sample No. | Description | Ni-layer (µm) | Cr-layer (nm) | Eff (%) | 5-10% | <5% |
|---|---|---|---|---|---|---|
| 1 | BP+MF + Cr | - | 7 | 10.7 | 93 | 26 |
| 2 | BP+MF + Cr | - | 15 | 7.8 | 100 | 89 |
| 3 | BP+MF + Cr | - | 100 | 15.3 | 22 | 4 |
| 5 | BP+MF + Ni + Cr | 2 | - | 5.7 | 100 | 93 |
| 6 | BP+MF + Ni + Cr | 2 | 7 | 10.5 | 72 | 43 |
| 8 | BP+MF + Ni + Cr | 2 | 100 | 14.8 | 48 | 15 |
| 9 | BP+MF + Ni + Cr | 2 | 100 | 14.9 | 10 | 0 |
| 10 | DA after Ni-plating +Cr | 2 | 7 | 10.6 | 75 | 11 |

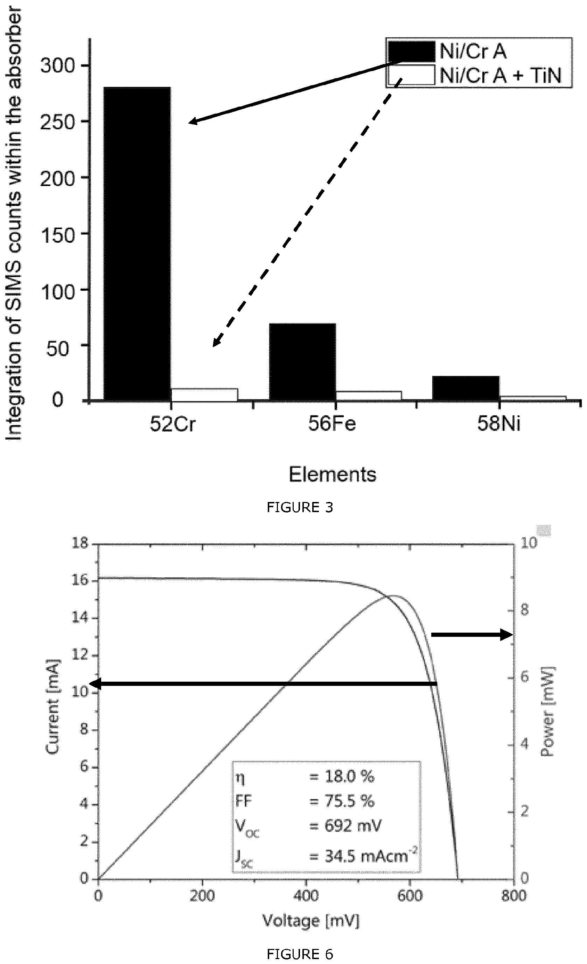

Detrimental elements like Fe, Cr or Ni can introduce defects in the CIGS absorber layer. As a consequence the efficiency of the device decreases. A decreasing VOC (Voltage Open Circuit) is an indirect indication for detrimental elements like Fe, Ni or Cr present in the absorber layer. In the case without an additional TiN barrier layer between the barrier layer and the molybdenum back contact layer 4 the VOC significantly drops. This effect is stronger with higher Fe impurity content within the absorber layer. Elemental depth profiles measured using SIMS measurements showed that at temperatures above 500 °C the Cr and Fe content is roughly 10 times higher in the case without an additional TiN barrier coating. Figure 3 shows SIMS Elemental counts within the absorber layer. The measured Fe, Ni and Cr concentrations are very low and for the low values very close to the detection limit of the used device.

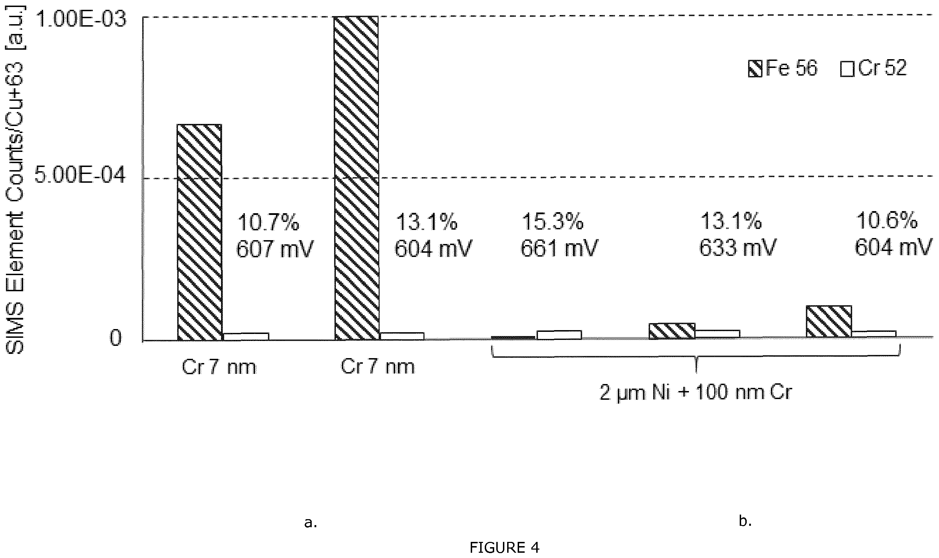

Comparing the efficiencies at 450 and 500 °C deposition temperature the decrease in efficiency is low. The only outlier is sample 2 which performs well at 450 °C but is poor at 500 °C. It is believed that this strong decrease is the result of increased defect levels in the Cr layer, due to plating bath used. Figure 4a shows that a layer of 7 nm chromium is not able to prevent the migration of iron into the absorber. Figure 4b on the other hand shows that a 2 µm Nickel layer combined with a 100 nm chromium layer is able to prevent this to a large extent. The figure also shows a clear correlation with efficiency and VOC values, with decreasing values with increasing iron content in the absorber layer. This figure give support for the need to use a thicker Cr-layer to obtain good efficiency, high VOC and a good corrosion resistance.

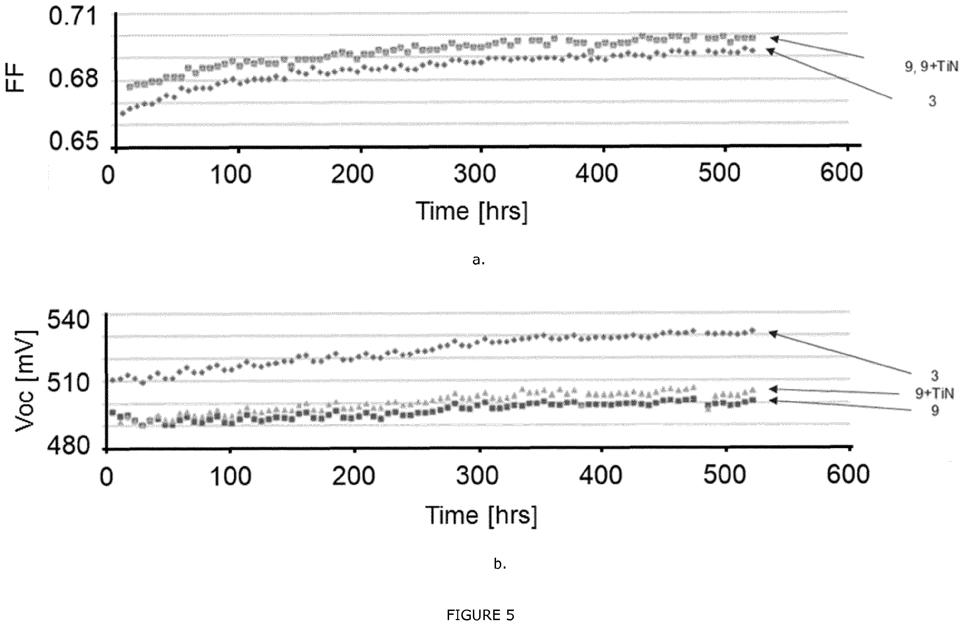

Figure 5 shows the performance of samples 3 and 9 in terms of the fill factor (FF) and the Voltage Open Circuit (VOC). The FF and the VOC values even increase after 500 hrs, indicative of the effective prevention of the diffusion of detrimental elements into the absorber layer. Results show that after 1000 h of accelerated stress tests the CIGS solar cells still provide 99% of their original power. The test conditions in Figure 5a and b are 1 Sun illumination, 80 °C, MPP (maximum power point). It is noted that CIGS based thin-film solar cells on metal substrate have been produced according to the invention having an efficiency of 18%! (See Figure 6).

There is evidence that the surface roughness of the mild steel affects the performance of the solar cell. It is therefore preferable that the roughness of the mild steel is at least in the category of Bright Finish, more preferably in the category of Mirror Finish.

## Claims

1. A Cu(In,Ga)Se₂ (CIGS)-based thin-film solar cell, comprising a mild steel substrate (1) having a thickness of between 0.025 and 3.0 mm coated on at least one side with a nickel layer (2) on top thereof and a chromium layer (3) on top of the nickel layer to form a coated mild steel substrate (4), the nickel and chromium layers jointly forming a barrier layer, wherein the coated mild steel substrate is further coated with a CIGS-based solar cell comprising:
a) a molybdenum back contact layer (5)
b) a CIGS active layer (6)
c) an n-type semiconductor layer such as a CdS or a ZnS layer (7)
d) a transparent conductive oxide (TCO) layer (8), wherein the nickel layer thickness is between 0.25 and 5.5 µm, and the chromium layer thickness is between 0.01 and 0.30 µm.

2. A solar cell according to claim 1 wherein a dielectric layer (9) is provided between the coated mild steel substrate (4) and the molybdenum back contact layer (5).

3. A solar cell according to claim 2 wherein the dielectric layer (9) is a metal oxide layer, a silica layer, a nitride or a carbide layer.

4. A solar cell according to any one of the preceding claims wherein the CIGS active layer (6) was grown at a temperature of at least 400 °C onto the molybdenum back contact layer on a coated mild steel substrate.

5. A solar cell according to any one of the preceding claims wherein the roughness of the mild steel substrate is Rₐ ≦ 0.4 µm, preferably Rₐ ≦ 0.1 µm.

6. A solar cell according to any one of the preceding claims further provided with a Ni/Al grid and a MgF₂-anti reflection coating on top of the TCO.

7. A solar cell according to claim 1 wherein the mild steel substrate is provided on the top side of the substrate with the barrier layer according to claim 1 and wherein the bottom side of the substrate is provided with at least one of the following layers
a) a corrosion protective coating layer, such as a nickel layer;
b) the barrier layer according to claim 1, optionally with different thickness of the nickel and/or chromium layer.

8. A solar cell according to any one of the preceding claims further provided with a TiN barrier layer (10) between the molybdenum back contact layer (5) and the coated mild steel substrate (4).

9. Method of producing a Cu(In,Ga)Se₂ (CIGS)-based thin-film solar cell, comprising the following subsequent process steps:
a) Providing a mild steel substrate (1) having a thickness of between 0.025 and 3.0 mm;
b) Forming a barrier layer by coating the mild steel substrate with a nickel layer (2) having a thickness of between 0.25 and 5.5 µm and by coating the nickel layer with a chromium layer the chromium layer (3) having a thickness of between 0.01 and 0.30 µm from a trivalent chromium plating bath;
c) Coating the chromium layer with a molybdenum back contact layer (5);
d) Growing a CIGS active layer (6) at a temperature of at least 400 °C;
e) Depositing an n-type semiconductor layer such as a CdS or a ZnS layer (7);
f) Depositing a transparent conductive oxide (TCO) layer (8).

10. Method according to claim 9 wherein a dielectric layer (9) is provided between the coated mild steel substrate (4) and the molybdenum back contact layer (5).

11. Method according to claim 10 wherein the dielectric layer (9) is a metal oxide layer, a silica layer, a nitride layer or a carbide layer.

12. Method according to any one of claims 9 to 11 wherein the TCO-layer is provided with an electron-beam evaporated Ni/Al grid and optionally with a MgF₂-anti reflection coating.

13. Method according to any one of claims 9 to 12 wherein the roughness of the mild steel substrate is Rₐ ≦ 0.4 µm, preferably Rₐ ≦ 0.1 µm.

14. Method according to any one of the claims 9 to 13 further provided with a TiN barrier layer (10) between the molybdenum back contact layer (5) and the coated mild steel substrate (4).

15. Method according to any one of claims 9 to 14 wherein the mild steel substrate is provided on the top side of the substrate with the barrier layer according to claim 9 and wherein the bottom side of the substrate is provided with at least one of the following layers:
a) a corrosion protective coating layer, such as a nickel layer;
b) the barrier layer according to claim 9, optionally with different thickness of the nickel and/or chromium layer.

## Patentansprüche

1. Cu(In,Ga)Se₂ (CIGS)-basierte-Dünnschicht-Solarzelle, die ein Weichstahlsubstrat (1) mit einer Dicke zwischen 0,025 und 3,0 mm umfasst, überzogen auf mindestens einer Seite mit einer Nickelschicht (2) auf der Oberseite und einer Chromschicht (3) auf der Oberseite der Nickelschicht, um ein überzogenes Weichstahlsubstrat (4) zu bilden, wobei die Nickel- und Chromschichten gemeinsam eine Barrierenschicht bilden, wobei das überzogene Weichstahlsubstrat ferner mit einer CIGS-basierten Solarzelle überzogen ist, umfassend:
a) eine Molybdän-Back-Contact-Schicht (5);
b) eine aktive CIGS-Schicht (6);
c) eine n-Typ-Halbleiterschicht, wie etwa eine CdS- oder eine ZnS-Schicht (7);
d) eine Schicht (8) aus einem transparenten, elektrisch leitfähigen Oxid (TCO), wobei die Dicke der Nickelschicht zwischen 0,25 und 5,5 µm liegt, und wobei die Dicke der Chromschicht zwischen 0,01 und 0,30 µm liegt.

2. Solarzelle nach Anspruch 1, wobei zwischen dem überzogenen Weichstahlsubstrat (4) und der Molybdän-Back-Contact-Schicht (5) eine dielektrische Schicht (9) bereitgestellt ist.

3. Solarzelle nach Anspruch 2, wobei die dielektrische Schicht (9) eine Metalloxidschicht, eine Siliziumoxidschicht, eine Nitrid- oder eine Carbidschicht ist.

4. Solarzelle nach einem der vorstehenden Ansprüche, wobei die aktive CIGS-Schicht (6) auf einer Temperatur von mindestens 400 °C auf die Molybdän-Back-Contact-Schicht auf einem überzogenen Weichstahlsubstrat gezüchtet worden ist.

5. Solarzelle nach einem der vorstehenden Ansprüche, wobei die Rauheit des Weichstahlsubstrats Rₐ ≤ 0,4 µm ist, vorzugsweise Rₐ ≤ 0,1 µm.

6. Solarzelle nach einem der vorstehenden Ansprüche, die ferner mit einem Ni/Al-Gitter und eine MgF₂-Antireflexbeschichtung auf der Oberseite des TCO bereitgestellt ist.

7. Solarzelle nach Anspruch 1, wobei das Weichstahlsubstrat auf der Oberseite des Substrats mit der Barrierenschicht gemäß Anspruch 1 bereitgestellt ist, und wobei die Unterseite des Substrats mit mindestens einer der folgenden Schichten bereitgestellt ist:
a) einer Korrosionsschutz-Überzugsschicht, wie etwa einer Nickelschicht;
b) einer Barrierenschicht nach Anspruch 1, optional mit unterschiedlicher Dicke der Nickel- und/oder Chromschicht.

8. Solarzelle nach einem der vorstehenden Ansprüche, die ferner zwischen der Molybdän-Back-Contact-Schicht (5) und dem überzogenen Weichstahlsubstrat (4) mit einer TiN-Barrierenschicht (10) bereitgestellt ist.

9. Verfahren zum Herstellen einer Cu(In,Ga)Se₂ (CIGS)-basierten-Dünnschicht-Solarzelle, das die folgenden aufeinanderfolgenden Verfahrensschritte umfasst:
a) Bereitstellen eines Weichstahlsubstrats (1) mit einer Dicke zwischen 0,025 und 3,0 mm;
b) Bilden einer Barrierenschicht durch Überziehen des Weichstahlsubstrats mit einer Nickelschicht (2) mit einer Dicke zwischen 0,25 und 5,5 µm und Überziehen der Nickelschicht mit einer Chromschicht, wobei die Chromschicht (3) eine Dicke zwischen 0,01 und 0,30 µm aus einem trivalenten Verchromungsbad umfasst;
c) Überziehen der Chromschicht mit einer Molybdän-Back-Contact-Schicht (5);
d) Züchten einer aktiven CIGS-Schicht (6) auf einer Temperatur von mindestens 400 °C;
e) Abscheiden einer n-Typ-Halbleiterschicht, wie etwa einer CdS- oder einer ZnS-Schicht (7);
f) Abscheiden einer Schicht (8) aus einem transparenten, elektrisch leitfähigen Oxid (TCO).

10. Verfahren nach Anspruch 9, wobei zwischen dem überzogenen Weichstahlsubstrat (4) und der Molybdän-Back-Contact-Schicht (5) eine dielektrische Schicht (9) bereitgestellt wird.

11. Verfahren nach Anspruch 10, wobei die dielektrische Schicht (9) eine Metalloxidschicht, eine Siliziumoxidschicht, eine Nitrid- oder eine Carbidschicht ist.

12. Verfahren nach einem der Ansprüche 9 bis 11, wobei die TCO-Schicht bereitgestellt wird mit einem Elektronenstrahl verdampften Ni/Al-Gitter und optional mit einer MgF₂-Antireflexbeschichtung.

13. Verfahren nach einem der Ansprüche 9 bis 12, wobei die Rauheit des Weichstahlsubstrats Rₐ ≤ 0,4 µm ist, vorzugsweise Rₐ ≤ 0,1 µm.

14. Verfahren nach einem der Ansprüche 9 bis 13, ferner bereitgestellt mit einer TiN-Barrierenschicht (10) zwischen der Molybdän-Back-Contact-Schicht (5) und dem überzogenen Weichstahlsubstrat (4).

15. Verfahren nach einem der Ansprüche 9 bis 14, wobei das Weichstahlsubstrat auf der Oberseite des Substrats mit der Barrierenschicht gemäß Anspruch 9 bereitgestellt ist, und wobei die Unterseite des Substrats mit mindestens einer der folgenden Schichten bereitgestellt ist:
a) einer Korrosionsschutz-Überzugsschicht, wie etwa einer Nickelschicht;
b) einer Barrierenschicht nach Anspruch 9, optional mit unterschiedlicher Dicke der Nickel- und/oder Chromschicht.

## Revendications

1. Cellule solaire à couche mince à base de Cu(In,Ga)Se₂ (CIGS), comprenant un substrat en acier doux (1) ayant une épaisseur comprise entre 0,025 et 3,0 mm revêtu sur au moins un côté d'une couche de nickel (2) sur son dessus et d'une couche de chrome (3) sur le dessus de la couche de nickel pour former un substrat en acier doux revêtu (4), les couches de nickel et de chrome formant conjointement une couche barrière, le substrat en acier doux revêtu étant en outre revêtu d'une cellule solaire à base de CIGS comprenant :
a) une couche de contact arrière de molybdène (5),
b) une couche active de CIGS (6),
c) une couche semi-conductrice de type n telle qu'une couche de CdS ou de ZnS (7),
d) une couche d'oxyde conducteur transparent (TCO) (8), l'épaisseur de la couche de nickel étant comprise entre 0,25 et 5,5 µm, et l'épaisseur de la couche de chrome étant comprise entre 0,01 et 0,30 µm.

2. Cellule solaire selon la revendication 1, une couche diélectrique (9) étant fournie entre le substrat en acier doux revêtu (4) et la couche de contact arrière de molybdène (5).

3. Cellule solaire selon la revendication 2, la couche diélectrique (9) étant une couche d'oxyde métallique, une couche de silice, une couche de nitrure ou une couche de carbure.

4. Cellule solaire selon l'une quelconque des revendications précédentes, la couche active de CIGS (6) ayant été cultivée à une température d'au moins 400 °C sur la couche de contact arrière de molybdène sur un substrat en acier doux revêtu.

5. Cellule solaire selon l'une quelconque des revendications précédentes, la rugosité du substrat en acier doux étant Rₐ ≤ 0,4 µm, de préférence Rₐ ≤ 0,1 µm.

6. Cellule solaire selon l'une quelconque des revendications précédentes, pourvue d'un réseau de Ni/Al et d'un revêtement antireflet de MgF₂ sur la TCO.

7. Cellule solaire selon la revendication 1, le substrat en acier doux étant pourvu sur le côté supérieur du substrat de la couche barrière selon la revendication 1 et le côté inférieur du substrat étant pourvu d'au moins une des couches suivantes
a) une couche de revêtement de protection contre la corrosion, telle qu'une couche de nickel ;
b) la couche barrière selon la revendication 1, éventuellement avec une épaisseur différente de la couche de nickel et/ou de chrome.

8. Cellule solaire selon l'une quelconque des revendications précédentes, pourvue en outre d'une couche barrière de TiN (10) entre la couche de contact arrière de molybdène (5) et le substrat en acier doux revêtu (4).

9. Procédé de fabrication d'une cellule solaire à couche mince à base de Cu(In,Ga)Se₂ (CIGS), comprenant les étapes de procédé subséquentes consistant à :
a) fournir un substrat en acier doux (1) ayant une épaisseur comprise entre 0,025 et 3,0 mm ;
b) former une couche barrière en recouvrant le substrat en acier doux d'une couche de nickel (2) ayant une épaisseur comprise entre 0,25 et 5,5 µm et en revêtant la couche de nickel d'une couche de chrome, la couche de chrome (3) ayant une épaisseur comprise entre 0,01 et 0,30 µm, à partir d'un bain de chromage trivalent ;
c) revêtir la couche de chrome avec une couche de contact arrière de molybdène (5) ;
d) cultiver d'une couche active de CIGS (6) à une température d'au moins 400 °C ;
e) déposer une couche semi-conductrice de type n telle qu'une couche de CdS ou de ZnS (7) ;
f) déposer une couche d'oxyde conducteur transparent (TCO) (8).

10. Procédé selon la revendication 9, une couche diélectrique (9) étant fournie entre le substrat en acier doux revêtu (4) et la couche de contact arrière de molybdène (5).

11. Procédé selon la revendication 10, la couche diélectrique (9) étant une couche d'oxyde métallique, une couche de silice, une couche de nitrure ou une couche de carbure.

12. Procédé selon l'une quelconque des revendications 9 à 11, la couche de TCO étant pourvue d'une grille en Ni/AI évaporé par faisceau d'électrons et, éventuellement, d'un revêtement antireflet de MgF₂.

13. Procédé selon l'une quelconque des revendications 9 à 12, la rugosité du substrat en acier doux étant Rₐ ≤ 0,4 µm, de préférence Rₐ ≤ 0,1 µm.

14. Procédé selon l'une quelconque des revendications 9 à 13, pourvu en outre d'une couche barrière de TiN (10) entre la couche de contact arrière de molybdène (5) et le substrat en acier doux revêtu (4).

15. Procédé selon l'une quelconque des revendications 9 à 14, le substrat en acier doux étant pourvu sur le côté supérieur du substrat de la couche barrière selon la revendication 9 et le côté inférieur du substrat étant pourvu d'au moins une des couches suivantes :
a) une couche de revêtement de protection contre la corrosion, telle qu'une couche de nickel ;
b) la couche barrière selon la revendication 9, éventuellement avec une épaisseur différente de la couche de nickel et/ou de chrome.
